# EUROPEAN PATENT APPLICATION

(11) **EP 4 571 851 A1**
(43) Date of publication of application: **18.06.2025**
(21) Application number: 23869787.4
(22) Date of filing: 27.06.2023
(51) Int. Cl.: H01L 31/0352

(54) **AVALANCHE PHOTODIODE (APD), RELATED DEVICE AND NETWORK**

(30) Priority: 30.09.2022 CN 202211212900
(71) Applicant: Huawei Technologies Co., Ltd., Shenzhen, Guangdong 518129 (CN)
(72) Inventor: ZHANG, Zhenhua, Shenzhen, Guangdong 518129 (CN); CAO, Rixiang, Shenzhen, Guangdong 518129 (CN); QIU, Xiaodong, Shenzhen, Guangdong 518129 (CN)
(74) Representative: Pfenning, Meinig & Partner mbB
(86) International application number: PCT/CN2023/102707
(87) International publication number: WO 2024/066539

(57) **Abstract**

Embodiments of this application disclose an avalanche photodiode APD, a related device, and a network, to reduce excess noise of the APD. The APD provided in embodiments of this application includes an absorption layer, a multiplication layer, and a first ohmic contact layer. The multiplication layer includes a plurality of inclined electric field structures distributed on a first plane. The absorption layer and the first ohmic contact layer are on different sides of the first plane, and a charge carrier generated on the absorption layer is transmitted to the first ohmic contact layer after passing through the plurality of inclined electric field structures. The plurality of inclined electric field structures are used to accelerate the charge carrier.

## Description

This application claims priority to Chinese Patent Application No. 202211212900.3, filed with the China National Intellectual Property Administration on September 30, 2022 and entitled "AVALANCHE PHOTODIODE APD, RELATED DEVICE, AND NETWORK", which is incorporated herein by reference in its entirety.

### TECHNICAL FIELD

Embodiments of this application relate to the semiconductor field, and in particular, to an avalanche photodiode APD, a related device, and a network.

### BACKGROUND

A photoelectric detector is configured to convert an optical signal into an electrical signal. An avalanche photodiode (avalanche photodiode, APD) is a common photoelectric detector. The APD amplifies a signal using an avalanche multiplication effect of a charge carrier, to achieve higher detection sensitivity.

In the APD, different photogenerated charge carriers have different multiplication gains, making a multiplied current have a characteristic of random fluctuation. Additional noise introduced by such fluctuation is referred to as multiplication noise, also referred to as excess noise.

Some scenarios have high requirements for APD sensitivity. If the excess noise of the APD is excessively high, a signal-to-noise ratio is excessively low, and consequently the APD cannot meet the sensitivity requirement.

### SUMMARY

Embodiments of this application provide an avalanche photodiode APD, a related device, and a network, to accelerate a charge carrier by using a plurality of inclined electric field structures, so as to reduce excess noise and improve sensitivity of the APD.

According to a first aspect, an embodiment of this application provides an avalanche photodiode APD. The APD includes an absorption layer, a multiplication layer, and a first ohmic contact layer. The multiplication layer includes a plurality of inclined electric field structures distributed on a first plane. The absorption layer and the first ohmic contact layer are on different sides of the first plane. The absorption layer may generate a charge carrier (photogenerated charge carrier), and the charge carrier generated on the absorption layer is transmitted to the first ohmic contact layer after passing through the plurality of inclined electric field structures. The plurality of inclined electric field structures are used to accelerate the charge carrier flowing through.

In this embodiment of this application, the inclined electric field structures may generate inclined electric fields, such that a part closer to the first ohmic contact layer has higher electric field strength. In the multiplication layer, the charge carrier is accelerated by using the inclined electric fields of the plurality of inclined electric field structures, and a location at which avalanche ionization is performed on the charge carrier is controlled to be at a location (that is, a location that is on the multiplication layer and that is closer to the first ohmic contact layer) with higher electric field strength. In this way, regions in which the avalanche ionization is performed on the charge carrier are more concentrated, to reduce randomness of the avalanche ionization, reduce an equivalent k value of the APD, and reduce excess noise of the APD.

In an optional implementation, the multiplication layer is located in a first direction of (for example, below) the absorption layer, and the charge carrier generated on the absorption layer flows through the multiplication layer in the first direction. The multiplication layer further includes at least one connection region, and the at least one connection region is used to separate the plurality of inclined electric field structures. At least one groove corresponding to the at least one connection region is provided on the absorption layer, and the at least one connection region is in the first direction of the at least one groove.

In this embodiment of this application, at the multiplication layer, the plurality of inclined electric field structures are regions with a low k value because the plurality of inclined electric field structures can generate the inclined electric fields; and the connection region has a high k value because the connection region has no function of generating an inclined electric field. The groove corresponding to the connection region is provided on the absorption layer, so that a quantity of charge carriers (photogenerated charge carriers) generated at a location (that is, a location of the groove) that corresponds to the connection region and that is on the absorption layer is reduced, thereby reducing a quantity of charge carriers that flow through the connection region, reducing the equivalent k value of the APD, and reducing the excess noise of the APD.

In an optional implementation, the absorption layer is penetrated by the at least one groove.

In this embodiment of this application, the absorption layer is penetrated by the groove, so that the charge carrier can be prevented from being generated in the absorption layer region above the connection region, and the quantity of charge carriers that flow through the connection region can be better reduced, thereby better reducing the equivalent k value of the APD and reducing the excess noise of the APD.

In an optional implementation, a bottom of the at least one groove is in the absorption layer (that is, the absorption layer is not penetrated by the at least one groove).

In this embodiment of this application, in comparison with penetrating the absorption layer, if the at least one groove does not penetrate the absorption layer, a material of the absorption layer in contact with the bottom of the groove can enhance structural stability of the absorption layer, thereby enhancing structural stability of the APD.

In an optional implementation, the multiplication layer is located in a first direction of (for example, below) the absorption layer, and the charge carrier generated on the absorption layer flows through the multiplication layer in the first direction. The multiplication layer further includes at least one connection region, and the at least one connection region is used to separate the plurality of inclined electric field structures. The absorption layer includes at least one light shielding region corresponding to the at least one connection region, and the at least one connection region is in the first direction of the at least one light shielding region.

In this embodiment of this application, at the multiplication layer, the plurality of inclined electric field structures are regions with a low k value because the plurality of inclined electric field structures can generate the inclined electric fields; and the connection region has a high k value because the connection region has no function of generating an inclined electric field. A quantity of charge carriers (photogenerated charge carriers) generated at a location (that is, a location of the light shielding region) that corresponds to the connection region and that is on the absorption layer is reduced with the light shielding region that corresponds to the connection region and that is on the absorption layer, thereby reducing a quantity of charge carriers that flow through the connection region, reducing the equivalent k value of the APD, and reducing the excess noise of the APD.

In an optional implementation, the APD further includes a second ohmic contact layer, where the second ohmic contact layer and the multiplication layer are on different sides of the absorption layer. A plurality of holes are provided on a side (for example, an upper surface of the APD) that is of the second ohmic contact layer and that is away from the absorption layer, and the plurality of holes form a metasurface structure.

In this embodiment of this application, transverse resonance of light may be implemented by using the metasurface structure, to increase a light absorption rate of the absorption layer, and improve responsivity of the APD.

In an optional implementation, the APD further includes the second ohmic contact layer, where the second ohmic contact layer and the multiplication layer are on different sides of the absorption layer. A plurality of protrusions are included on a side (for example, an upper surface of the APD) that is of the second ohmic contact layer and that is away from the absorption layer, and the plurality of protrusions form a metasurface structure.

In this embodiment of this application, transverse resonance of light may be implemented by using the metasurface structure, to increase a light absorption rate of the absorption layer, and improve responsivity of the APD.

In an optional implementation, the multiplication layer includes the inclined electric field structures and a multiplication layer substrate. Doping concentrations of the inclined electric field structures are lower than a doping concentration of the multiplication layer substrate, and the inclined electric field structures are between the multiplication layer substrate and the absorption layer.

In an optional implementation, the absorption layer, the multiplication layer, and the first ohmic contact layer include a III-V material or a Ge/Si system material.

According to a second aspect, an embodiment of this application provides a collection device, where the collection device includes the APD according to the first aspect.

According to a third aspect, an embodiment of this application provides an optical communication device, where the optical communication device includes the APD according to the first aspect.

According to a fourth aspect, an embodiment of this application provides an optical communication network, where the optical communication network includes the optical communication device according to the third aspect.

For beneficial effects of the second aspect to the fourth aspect, refer to the first aspect. Details are not described herein again.

### BRIEF DESCRIPTION OF DRAWINGS

FIG. 1 is a diagram of an application scenario of an avalanche photodiode;
FIG. 2 is a diagram of a structure of an avalanche photodiode according to this application;
FIG. 3 is a diagram of a structure of an avalanche photodiode according to an embodiment of this application;
FIG. 4 is a diagram of inclined electric fields according to an embodiment of this application;
FIG. 5 is a diagram of inclined electric field structures according to an embodiment of this application;
FIG. 6 is a diagram of a structure of an avalanche photodiode including a groove according to an embodiment of this application;
FIG. 7 is a diagram of a structure of an avalanche photodiode including a light shielding region according to an embodiment of this application;
FIG. 8 is a diagram of a structure of an avalanche photodiode including a metasurface structure according to an embodiment of this application; and
FIG. 9 is a diagram of an absorption rate of an avalanche photodiode including a metasurface structure according to an embodiment of this application.

### DESCRIPTION OF EMBODIMENTS

The following describes embodiments of this application with reference to the accompanying drawings. A person of ordinary skill in the art may learn that, with development of technologies and emergence of a new scenario, the technical solutions provided in embodiments of this application are also applicable to a similar technical problem.

In the specification, claims, and accompanying drawings of this application, the terms "first", "second", and the like are intended to distinguish between similar objects but do not necessarily indicate a specific order or sequence. It should be understood that the terms used in such a way are interchangeable in proper circumstances, and this is merely a discrimination manner that is used when objects having a same attribute are described in embodiments of this application. In addition, the terms "include", "have" and any other variants thereof mean to cover non-exclusive inclusion, so that a process, method, system, product, or device that includes a series of units is not necessarily limited to those units, but may include other units not expressly listed or inherent to such a process, method, product, or device. In addition, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one of a, b, or c may indicate: a, b, c, a and b, a and c, b and c, or a, b, and c, where a, b, and c may be singular or plural.

The following explains some terms in embodiments of this application.

k value: Ratio of ionization rates of charge carriers (the charge carriers include electron holes and electrons, where k value=ionization rate of the electron hole/ionization rate of the electron, or k value=ionization rate of the electron/ionization rate of the electron hole).

Equivalent k value: k value of a device obtained through calculation according to a device gain process theory.

An avalanche photodiode APD is a common photodiode for photoelectric conversion. The APD may be used in a device like a collection device or a communication device.

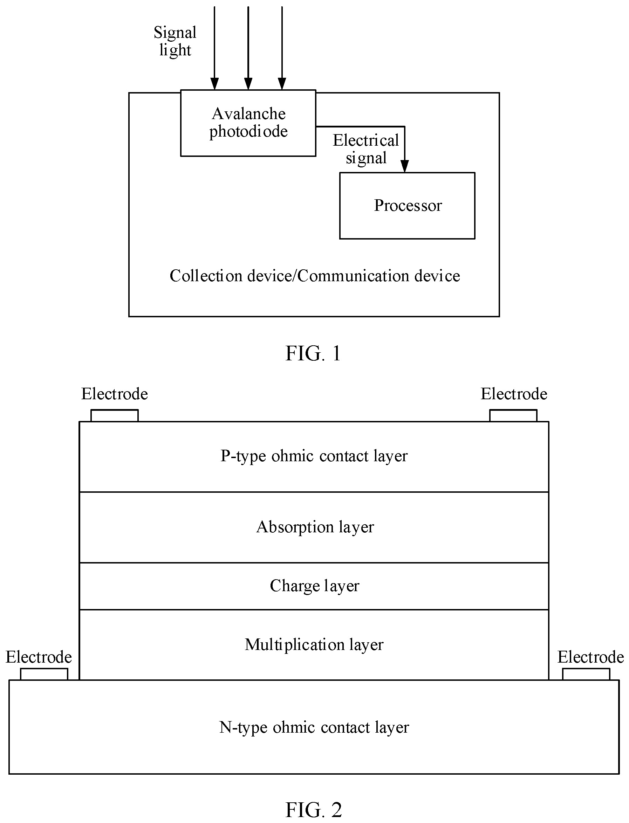

The collection device is used as an example. As shown in FIG. 1, the collection device may include the APD and a processor. The APD is configured to convert collected signal light into an electrical signal, and the processor is configured to process the electrical signal. For example, the processor may compress the electrical signal, upload the electrical signal to a network, and the like. This is not limited in this application. Optionally, the processor may be an image processing module, a graphics processing unit (graphics processing unit, GPU), or the like in the collection device. This is not limited in this application.

The APD may alternatively be used in another device, for example, the communication device. For example, the communication device in FIG. 1 may be an optical receiver, and the optical receiver includes the APD and a processor. The APD is configured to convert a communication optical signal into an electrical signal, and the processor is configured to process, for example, perform amplification, shaping, and noise reduction on, the electrical signal. This is not limited in this application. Optionally, the processor may be a communication chip, an operation circuit, or the like in the communication device. This is not limited in this application.

The APD amplifies a photoelectric signal using an avalanche multiplication effect of a charge carrier, to improve detection sensitivity. As shown in FIG. 2, a structure of the APD in this application includes a P-type ohmic contact layer, an absorption layer, a charge layer, a multiplication layer, and an N-type ohmic contact layer. The signal light is irradiated on the absorption layer, and a photogenerated charge carrier (also referred to as the charge carrier in this application for ease of description) is generated on the absorption layer. The charge carrier is transmitted to the multiplication layer through the charge layer, and avalanche multiplication occurs on the multiplication layer. That is, a quantity of charge carriers is increased, to implement signal amplification. The charge carrier moves to generate the electrical signal between the P-type ohmic contact layer and the N-type ohmic contact layer. The P-type ohmic contact layer and the N-type ohmic contact layer may include electrodes, and the electrodes are used to export the electrical signal.

The charge carrier generated on the absorption layer includes an electron and an electron hole. Multiplication gains of the multiplication layer for different charge carriers (electrons or electron holes) are random. As a result, a multiplied current has a random fluctuation characteristic. Additional noise introduced by this random fluctuation is referred to as multiplication noise, also referred to as excess noise.

Higher excess noise indicates a lower signal-to-noise ratio and lower sensitivity. In some scenarios that require high sensitivity, excessively high excess noise of the APD may cause a low signal-to-noise ratio, and the sensitivity requirement cannot be met.

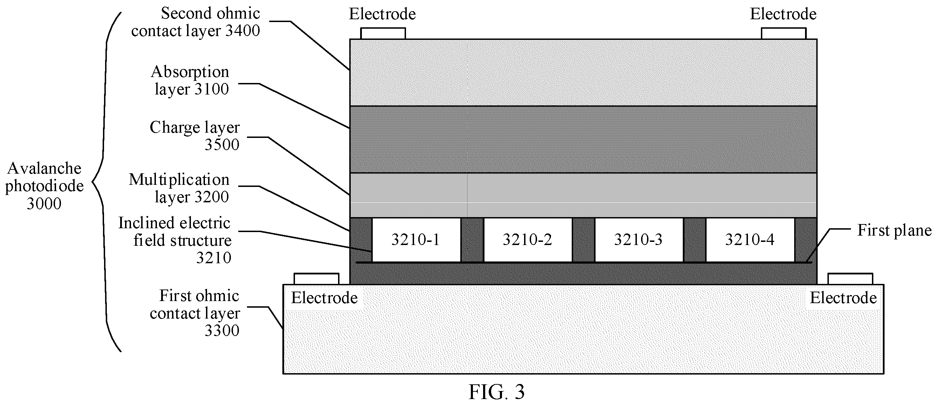

To remedy the foregoing defect, an embodiment of this application provides an APD structure, to accelerate a charge carrier by using a plurality of inclined electric field structures, so as to reduce excess noise and improve sensitivity. As shown in FIG. 3, an avalanche photodiode 3000 provided in this embodiment of this application includes an absorption layer 3100, a multiplication layer 3200, and a first ohmic contact layer 3300.

The multiplication layer 3200 includes a plurality of inclined electric field structures 3210 distributed on a first plane, for example, inclined electric field structures 3210-1 to 3210-4 shown in FIG. 3. The multiplication layer 3200 may form the inclined electric field structures 3210 through doping, ion implantation, special structures, and the like. This is not limited in this application.

In this embodiment of this application, the first plane is a distribution plane of the plurality of inclined electric field structures 3210. Therefore, the first plane may be an actual plane, or may be a virtual plane. For example, the first plane may be a plane for generating the inclined electric field structures 3210 in an APD processing process, or may be a virtual plane in the multiplication layer. This is not limited in this application.

The first plane may further be used to represent a location relationship between a plurality of inclined electric fields and different layers. Specifically, the absorption layer 3100 and the first ohmic contact layer 3300 are on different sides of the first plane. For example, as shown in FIG. 3, the absorption layer 3100 and the first ohmic contact layer 3300 are on different sides of (above and below) the first plane. Because the first plane is on the multiplication layer 3200, the absorption layer 3100 is above the multiplication layer 3200, and the first ohmic contact layer 3300 is below the multiplication layer 3200.

The absorption layer 3100 may generate a charge carrier (photogenerated charge carrier), and the charge carrier generated on the absorption layer 3100 is transmitted to the first ohmic contact layer 3300 after passing through the plurality of inclined electric field structures 3210. The plurality of inclined electric field structures 3210 are used to accelerate the charge carrier flowing through.

Optionally, the APD 3000 may further include a second ohmic contact layer 3400. The charge carrier moves to generate an electrical signal between the first ohmic contact layer 3300 and the second ohmic contact layer 3400. The first ohmic contact layer 3300 and the second ohmic contact layer 3400 may include electrodes, and the electrodes are used to export the electrical signal.

In this embodiment of this application, the first ohmic contact layer 3300 may be a P-type ohmic contact layer, and the second ohmic contact layer 3400 may be an N-type ohmic contact layer. Alternatively, the first ohmic contact layer 3300 may be an N-type ohmic contact layer, and the second ohmic contact layer 3400 may be a P-type ohmic contact layer. This is not limited in this application.

Optionally, the APD 3000 may further include a charge layer 3500, and the charge layer 3500 is used to adjust electric field distribution of the absorption layer 3100 and the multiplication layer 3200.

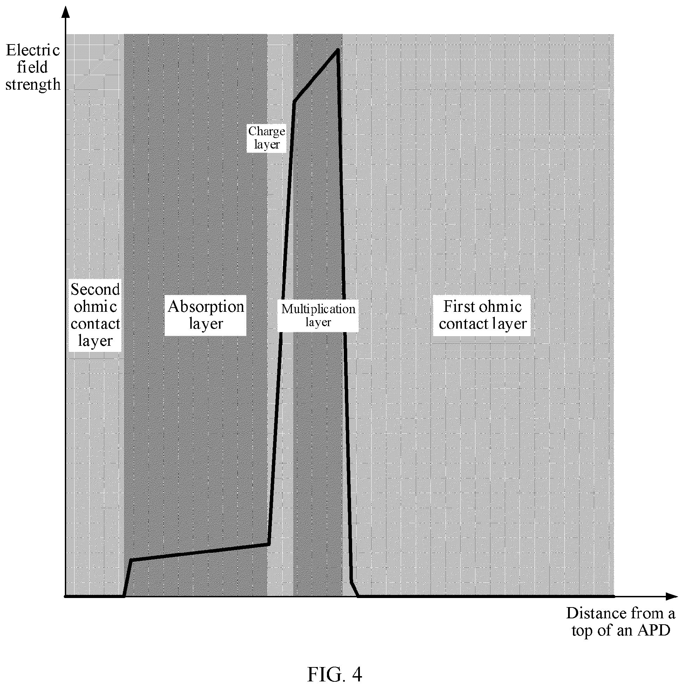

In this embodiment of this application, the inclined electric field structures 3210 may generate inclined electric fields. FIG. 4 is a diagram of the inclined electric fields. As shown in FIG. 4, in the multiplication layer 3200, a closer proximity to the first ohmic contact layer 3300 indicates higher electric field strength. In the multiplication layer 3200, the charge carrier is accelerated by using the inclined electric fields of the plurality of inclined electric field structures 3210, and a location at which avalanche ionization is performed on the charge carrier is controlled to be at a location (that is, a location that is on the multiplication layer 3200 and that is closer to the first ohmic contact layer 3300, for example, at a sharp corner on the multiplication layer in FIG. 4) with higher electric field strength. In this way, regions in which the avalanche ionization is performed on the charge carrier are more concentrated, to reduce randomness of the avalanche ionization, reduce an equivalent k value of the APD, and reduce excess noise of the APD.

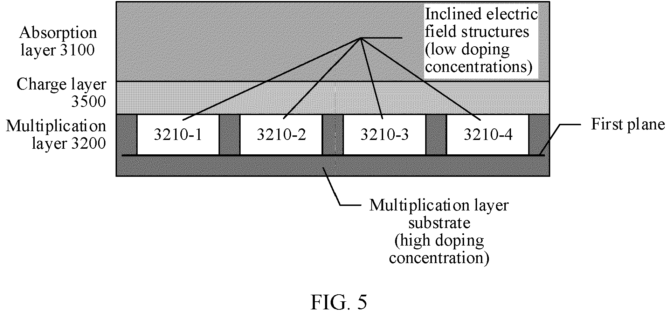

In this embodiment of this application, electric field non-uniformity may be constructed in a non-uniform doping manner, to generate the inclined electric field. As shown in FIG. 5, the multiplication layer 3200 may include the inclined electric field structures 3210 and a multiplication layer substrate. Doping concentrations of the inclined electric field structures 3210 are lower than a doping concentration of the multiplication layer substrate, and the inclined electric field structures 3210 are between the multiplication layer substrate and the absorption layer 3100. In the structure, based on doping concentration division, a part (inclined electric field structures 3210) close to the absorption layer 3100 has a low doping concentration, and a part (multiplication layer substrate) far away from the absorption layer 3100 has a high doping concentration. Therefore, the inclined electric fields are implemented on the multiplication layer, and the regions in which the avalanche ionization is performed on the charge carrier are more concentrated, to reduce the equivalent k value and the excess noise of the APD.

Optionally, the multiplication layer substrate may be InAlAs, Si, or the like. This is not limited in this application.

It should be noted that, in addition to the doping structure shown in FIG. 5, the inclined electric field structures may alternatively be implemented in another manner like ion implantation. This is not limited in this application.

In this embodiment of this application, the excess noise of the APD is reduced by using the plurality of inclined electric field structures 3210. Optionally, the equivalent k value may be further reduced by providing a groove, adding a light shielding region, or the like, to further reduce the excess noise of the APD.

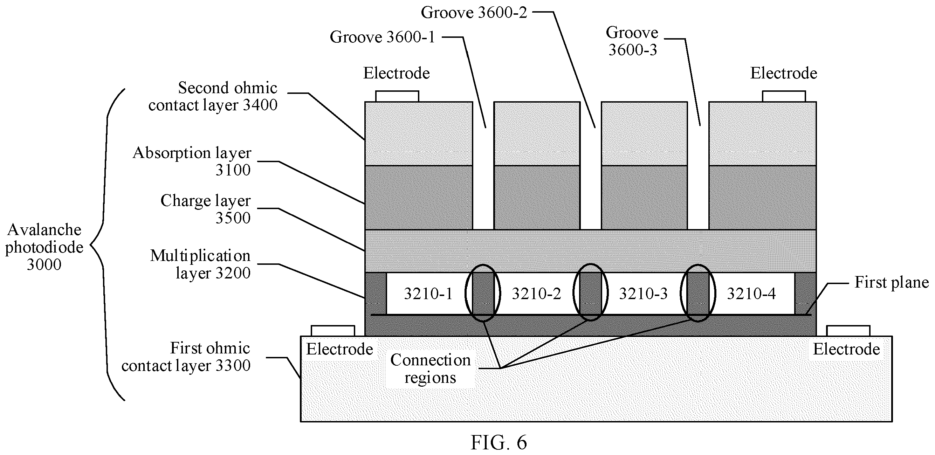

As shown in FIG. 6, the multiplication layer 3200 further includes at least one connection region. The connection region is used to separate the plurality of inclined electric field structures 3210 (for example, 3210-1 to 3210-4 in the figure). Because the inclined electric field structures 3210 may generate the inclined electric fields, the inclined electric field structures 3210 are regions with a low k value. Compared with the inclined electric field structures 3210, the connection region is a region with a high k value. Because the charge carrier generated on the absorption layer 3100 flows through the multiplication layer 3200 in a fixed direction, a region that corresponds to the connection region and that is on the absorption layer 3100 is found in the fixed direction, and a quantity of charge carriers generated in the region is limited, so that a quantity of charge carriers entering the region (connection region) with the high k value can be reduced, thereby reducing the equivalent k value of the APD and reducing the excess noise of the APD.

For example, as shown in FIG. 6, the charge carrier generated on the absorption layer 3100 flows downward through the multiplication layer 3200. In this case, at least one groove 3600 (for example, grooves 3600-1 to 3600-3 in the figure) may be provided on the absorption layer 3100, and the at least one groove 3600 is above the connection region.

Because the grooves 3600-1 to 3600-3 are provided, a quantity of charge carriers that are originally generated on the absorption layer 3100 and that flow through the connection region is reduced. Therefore, the equivalent k value of the APD may be reduced, and the excess noise may be reduced.

Optionally, as shown in FIG. 6, the groove 3600 may penetrate the absorption layer 3100, to better reduce the quantity of charge carriers that flow through the connection region, and reduce the excess noise.

Optionally, the groove 3600 may alternatively not penetrate the absorption layer 3100, so that a bottom of the groove 3600 is in the absorption layer 3100. In other words, a part of an absorption layer material is retained at a bottom (a part close to the charge layer) of the absorption layer 3100. In this embodiment of this application, the retained part of the absorption layer material can enhance structural stability of the absorption layer 3100, thereby enhancing structural stability of the APD 3000.

Optionally, the groove 3600 may be obtained through photoetching, development, etching, or the like. This is not limited in this application.

In this embodiment of this application, the groove 3600 may be a vertically downward groove, or may have another structure, for example, an angled bevel groove. This is not limited in this application.

Optionally, in this embodiment of this application, a non-conductive material (for example, silicon dioxide or silicon nitride) may be further filled in the groove 3600, to improve the structural stability of the APD.

Optionally, in addition to providing the groove 3600, the quantity of charge carriers that flow through the connection region may be reduced in another manner. This is not limited in this application. For example, a light shielding region may be added at a location that corresponds to the connection region and that is on a surface of the APD 3000.

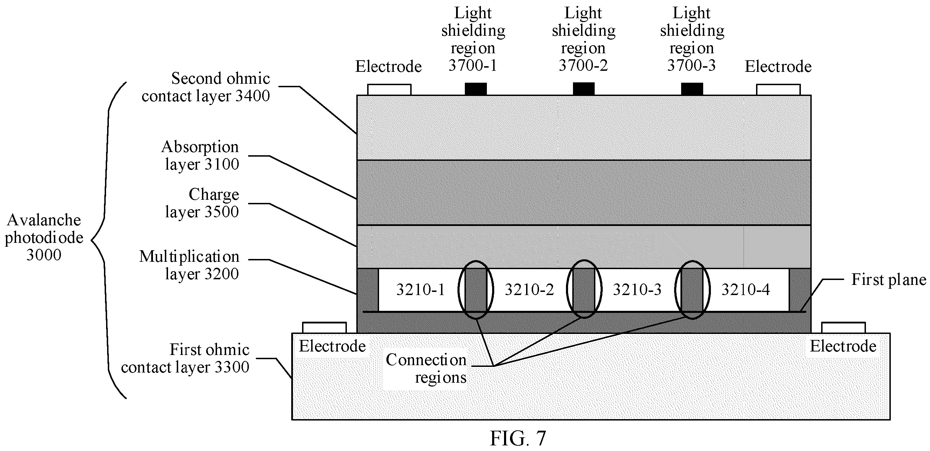

As shown in FIG. 7, the charge carrier generated on the absorption layer 3100 flows downward through the multiplication layer 3200. In this case, at least one light shielding region 3700 (for example, light shielding regions 3700-1 to 3700-3 in the figure) may be added on an upper surface of the surface (that is, the second ohmic contact layer 3400) of the APD 3000, and the at least one light shielding region 3700 is above the connection region.

In this embodiment of this application, the light shielding region 3700 is added to reduce the equivalent k value of the APD, so that the APD structure changes slightly, required processing precision is low, and implementation is easy.

In this embodiment of this application, a metasurface structure may be further added to the surface of the APD 3000, and a signal light absorption rate of the APD 3000 is increased by using the metasurface structure, to improve responsivity of the APD 3000.

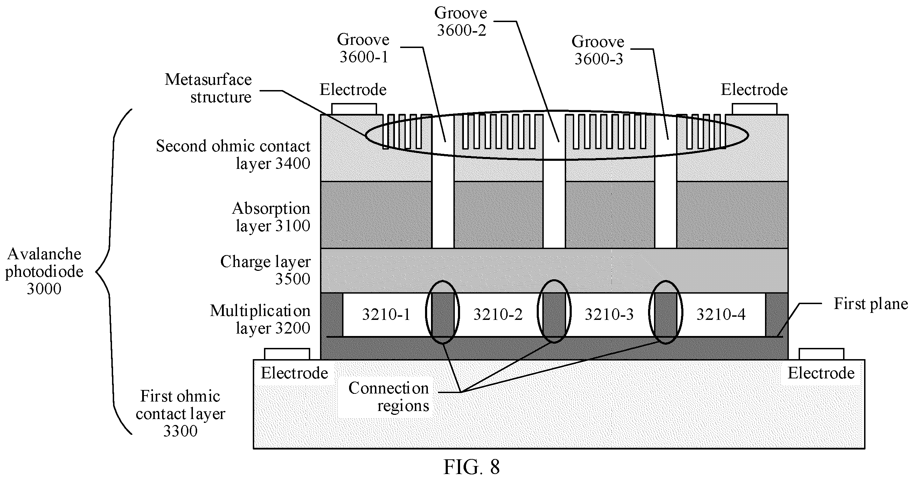

As shown in FIG. 8, a plurality of holes may be provided on the second ohmic contact layer 3400, and the plurality of holes may be periodically arranged to form the metasurface structure. When signal light is projected to the metasurface structure, transverse resonance may occur, so that the signal light absorption rate of the APD can be increased.

Micro-nano patterns of the plurality of holes in the metasurface structure may be any resonant structure. For example, cross-sectional shapes of the holes may be circles, ellipses, polygons, or other random shapes. Specific forms of the plurality of holes forming the metasurface structure are not limited in this embodiment of this application. The plurality of holes may be in one type of nanopores, nanopillars, nanospheres, nanorings, or nanorods, or may be a combination of the several types. This is not limited in this application.

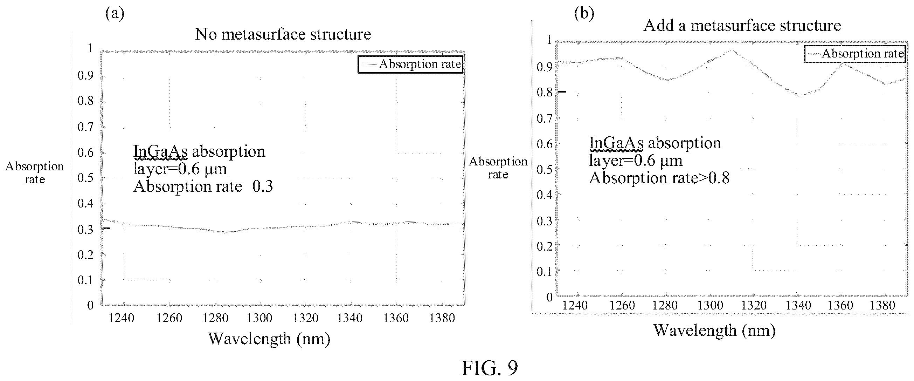

As shown in FIG. 9, when thicknesses of absorption layers 3100 are the same, the absorption rate may be increased from 0.3 to greater than 0.8 by adding the metasurface structure.

Optionally, in addition to providing the plurality of periodically arranged holes, the metasurface structure may alternatively be obtained by adding a plurality of periodically arranged protrusions or in another manner. For example, a plurality of protrusions may be added to the second ohmic contact layer 3400, and the plurality of protrusions may be periodically arranged to form the metasurface structure. Optionally, the metasurface structure may alternatively be a combination of periodically arranged holes and protrusions. This is not limited in this application.

Optionally, in addition to disposing the metasurface structure on the surface of the APD 3000 including the groove 3600, the metasurface structure may alternatively be disposed on the surface of the APD 3000 including the light shielding region 3700. This is not limited in this application.

The foregoing describes the structure of the APD 3000, and the following describes materials of layers of the APD 3000.

Optionally, the APD 3000 may be an APD of a III-V material. For example, in the APD 3000, the first ohmic contact layer 3300 and the second ohmic contact layer 3400 may be InP contact layers, the multiplication layer 3200 may be an InAlAs multiplication layer, the charge layer (between the absorption layer 3100 and the multiplication layer 3200) may be an InAlGaAs charge layer, and the absorption layer 3100 may be an InGaAs absorption layer.

Optionally, in addition to the III-V material, the APD 3000 provided in this embodiment of this application may alternatively be an APD of another material system, for example, a Ge/Si system material. This is not limited in this application. For example, in the APD 3000 of the Ge/Si system, the first ohmic contact layer 3300 may be an n-Si contact layer, the second ohmic contact layer 3400 may be a p+ contact layer, the multiplication layer 3200 may be an i-Si multiplication layer, the charge layer may be a p-Si charge layer, and the absorption layer 3100 may be an i-Ge absorption layer.

Optionally, the APD 3000 may alternatively be of another material system like a wide bandgap material system (for example, an AlGaN system) like ultraviolet. This is not limited in this application.

The foregoing describes the materials of the layers of the APD 3000, and the following describes a size of the APD 3000.

Optionally, in the APD 3000, a thickness of the second ohmic contact layer 3400 may range from 0.1 µm to 2 µm, a thickness of the absorption layer 3100 may range from 0.1 µm to 5 µm, a thickness of the charge layer may range from 0.01 µm to 1 µm, a thickness of the multiplication layer 3200 may range from 0.01 µm to 2 µm, and a thickness of the first ohmic contact layer 3300 may range from 0.1 µm to 2 µm.

Optionally, a diameter of a photosensitive surface of the APD 3000 may range from 10 µm to 200 µm, and the inclined electric field substructures 3210 may be below the photosensitive surface. Optionally, in the APD 3000, sizes of the inclined electric field structures 3210 may range from 0.1 µm to 30 µm.

Optionally, a size of the connection region may range from 0.1 µm to 2 µm. Correspondingly, a size of the groove 3600 (or the light shielding region 3700) may also range from 0.1 µm to 2 µm. This is not limited in this application. Optionally, a spacing between grooves 3600 (or light shielding regions 3700) may be determined based on the sizes of the inclined electric field structures 3210. For example, if the sizes of the inclined electric field structures 3210 range from 0.1 µm to 30 µm, a distance between adjacent grooves 3600 (or light shielding regions 3700) may also range from 0.1 µm to 30 µm.

The foregoing describes the size of the APD 3000, and the following describes processing techniques of the APD 3000.

Optionally, a first small mesa structure and a second mesa structure may be manufactured by using an etching technology like inductively coupled plasma (inductively coupled plasma, ICP) or reactive ion etching (Reactive ion etching, RIE). The first small mesa structure is an active region (for example, the second ohmic contact layer 3400, the absorption layer 3100, the charge layer 3500, the multiplication layer 3200, and the first ohmic contact layer 3300) of a detector, and the inclined electric field substructures 3210 are in the first small mesa structure. The second mesa structure may form the first ohmic contact layer 3300, above which the electrodes are placed.

Optionally, the metal electrodes of the first ohmic contact layer 3300 and the second ohmic contact layer 3400 may be deposited by using a metal coating technology like electron beam evaporation or magnetron sputtering.

Optionally, a silicon dioxide passivation layer may be deposited by using a plasma enhanced chemical vapor deposition (plasma enhanced chemical vapor deposition, PECVD) method, to protect an active structure (that is, the foregoing active region of the detector) of the APD 3000, and prevent a short circuit between a positive electrode and a negative electrode of the device and passivation of a side wall of the active region, so as to reduce a dark current of the APD 3000 and prevent premature breakdown of the APD 3000.

An embodiment of this application further provides a collection device, where the collection device includes the APD 3000 in any one of the foregoing embodiments. Optionally, a structure of the collection device may be shown in FIG. 1, where the avalanche photodiode is the APD 3000.

An embodiment of this application further provides an optical communication device, where the optical communication device includes the APD 3000 in any one of the foregoing embodiments. Optionally, a structure of the optical communication device may be shown in FIG. 1, where the avalanche photodiode is the APD 3000.

Optionally, the optical communication device may be an optical receiver, a reconfigurable optical add-drop multiplexer (reconfigurable optical add-drop multiplexer, ROADM), or the like. This is not limited in this application.

An embodiment of this application further provides an optical communication network, where the optical communication network includes the foregoing optical communication device.

It may be clearly understood by a person skilled in the art that, for the purpose of convenient and brief description, for detailed working processes of the foregoing described system, apparatus, and unit, refer to corresponding processes in the foregoing method embodiments. Details are not described herein again.

In the several embodiments provided in this application, it should be understood that the disclosed system, apparatus, and method may be implemented in other manners. For example, the foregoing described apparatus embodiments are merely examples. For example, division into the units is merely logic function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units, that is, may be located in one position, or may be distributed on a plurality of network units. Some or all of the units may be selected based on actual needs to achieve the objectives of the solutions of embodiments.

In addition, functional units in embodiments of this application may be integrated into one processing unit, each of the units may exist alone physically, or two or more units may be integrated into one unit.

## Claims

1. An avalanche photodiode APD, comprising: an absorption layer, a multiplication layer, and a first ohmic contact layer, wherein
the multiplication layer comprises a plurality of inclined electric field structures distributed on a first plane;
the absorption layer and the first ohmic contact layer are on different sides of the first plane, and a charge carrier generated on the absorption layer is transmitted to the first ohmic contact layer after passing through the plurality of inclined electric field structures; and
the plurality of inclined electric field structures are used to accelerate the charge carrier.

2. The APD according to claim 1, wherein the multiplication layer is located in a first direction of the absorption layer, and the charge carrier generated on the absorption layer flows through the multiplication layer in the first direction;
the multiplication layer further comprises at least one connection region, and the at least one connection region is used to separate the plurality of inclined electric field structures; and
at least one groove corresponding to the at least one connection region is provided on the absorption layer, and the at least one connection region is in the first direction of the at least one groove.

3. The APD according to claim 2, wherein the absorption layer is penetrated by the at least one groove.

4. The APD according to claim 2, wherein a bottom of the at least one groove is in the absorption layer.

5. The APD according to claim 1, wherein the multiplication layer is located in a first direction of the absorption layer, and the charge carrier generated on the absorption layer flows through the multiplication layer in the first direction;
the multiplication layer further comprises at least one connection region, and the at least one connection region is used to separate the plurality of inclined electric field structures; and
the absorption layer comprises at least one light shielding region corresponding to the at least one connection region, and the at least one connection region is in the first direction of the at least one light shielding region.

6. The APD according to any one of claims 1 to 5, further comprising a second ohmic contact layer, wherein the second ohmic contact layer and the multiplication layer are on different sides of the absorption layer; and
a plurality of holes are provided on a side that is of the second ohmic contact layer and that is away from the absorption layer, and the plurality of holes form a metasurface structure.

7. The APD according to any one of claims 1 to 6, further comprising the second ohmic contact layer, wherein the second ohmic contact layer and the multiplication layer are on different sides of the absorption layer; and
a plurality of protrusions are comprised on a side that is of the second ohmic contact layer and that is away from the absorption layer, and the plurality of protrusions form a metasurface structure.

8. The APD according to any one of claims 1 to 7, wherein the multiplication layer comprises the inclined electric field structures and a multiplication layer substrate; and
doping concentrations of the inclined electric field structures are lower than a doping concentration of the multiplication layer substrate, and the inclined electric field structures are between the multiplication layer substrate and the absorption layer.

9. The APD according to any one of claims 1 to 8, wherein the absorption layer, the multiplication layer, and the first ohmic contact layer comprise a III-V material or a Ge/Si system material.

10. A collection device, comprising the APD according to any one of claims 1 to 9.

11. An optical communication device, comprising the APD according to any one of claims 1 to 9.

12. An optical communication network, comprising the optical communication device according to claim 11.
